# EUROPÄISCHE PATENTSCHRIFT

(11) **EP 0 591 561 B1**
(45) Veröffentlichungstag und Bekanntmachung des Hinweises auf die Patenterteilung: **28.04.1999**
(21) Anmeldenummer: 92116741.7
(22) Anmeldetag: 30.09.1992
(51) Int. Cl.: G06F 1/24, H03K 17/22, H03M 1/34

(54) **Integrierte Schaltung zur Erzeugung eines Reset-Signals**
Integrated circuit for generating a reset signal
Circuit intégré pour générer un signal de remise à l'état initial

(43) Veröffentlichungstag der Anmeldung: 13.04.1994
(73) Patentinhaber: SIEMENS AKTIENGESELLSCHAFT, 80333 München (DE)
(72) Erfinder: Walter, Rudolph, W-8000 München 82 (DE)

(56) Entgegenhaltungen:
- EP-A- 0 090 330
- EP-A- 0 096 531
- EP-A- 0 496 018
- US-A- 4 948 995

## Beschreibung

Die Erfindung betrifft eine integrierte Schaltung zur Erzeugung eines Reset-Signals.

Beim Einschalten der Versorgungsspannung komplexer Schaltungen, insbesondere komplexer integrierter Schaltungen, besteht die Gefahr, daß einzelne Schaltungsteile einen undefinierten Zustand einnehmen. Undefinierte Zustände haben jedoch im allgemeinen Fehlfunktionen zur Folge bis hin zu Schäden an diesen Schaltungen oder an elektrischen Komponenten, die mit diesen Schaltungen verbunden sind.

Um besagte Fehlfunktionen ausschließen zu können, ist deshalb häufig eine sogenannte "Power-on-Resetschaltung" vorgesehen, die bei Anlegen der Versorgungsspannung einen meist einzelnen Signalimpuls (sog. Reset-Signal) erzeugt, der bezüglich des Einschaltens der Versorgungsspannung kritische Schaltungen oder Schaltungsteile gezielt in einen definierten Ausgangszustand versetzen soll, um so die obengenannten Nachteile zu vermeiden. Eine beispielhafte "Power-on-Resetschaltung", die eine solche Betriebsweise ermöglicht, kann dem Dokument US-A-4 948 995 entnommen werden. Diese weist eine Erkennungsschaltung auf, bestehend aus zwei p-Kanal-Transistoren und einem n-Kanal-Transistor, die zwischen den Anschlüssen einer Versorgungsspannung in Serie zueinander geschalten sind. Eine Ausgangssignalleitung der Erkennungsschaltung ist am Eingang einer CMOS-Inverterschaltung angeschlossen. Beim Einschalten der Versorgungsspannung wird so abhängig von dem Spannungspegel der Versorgungsspannung am Ausgang der CMOS-Inverterschaltung ein Reset-Signal erzeugt. Durch einen entsprechenden Schaltungsaufbau ist sichergestellt, daß bei inaktivem Reset-Signal die Stromaufnahme der Resetschaltung reduziert wird.

Aufgabe der vorliegenden Erfindung ist es, eine integrierte Schaltung zu schaffen zur Erzeugung eines Reset-Signals bei Anlegen der Versorgungsspannung, die folgende Vorgaben sicher erfüllt:
- Die Schaltung soll sowohl bei einem schnellen wie auch bei einem langsamen Anstieg der Versorgungsspannung sicher funktionieren,
- sie soll auch dann ansprechen, wenn der volle Wert der Versorgungsspannung die vom Hersteller der komplexen Schaltung vorgegebenen Grenzwerte der Versorgungsspannung unter- oder überschreitet,
- im Falle von Spannungsschwankungen der Versorgungsspannung im Betrieb, d.h. nach Anlegen der Versorgungsspannung und daraufhin bereits erfolgtem Reset-Vorgang, soll ein erneutes Aktivieren des Reset-Signals sicher verhindert werden,
- die Schaltung soll möglichst wenig Schaltelemente und einen möglichst geringen Platzbedarf aufweisen.

Weiterhin soll die zu schaffende integrierte Schaltung als Bestandteil einer komplexen integrierten Schaltung dienen können.

Diese Aufgabe wird gelöst mit einer integrierten Schaltung, die die Merkmale des Patentanspruches 1 aufweist.

Vorteilhafte Aus- und Weiterbildungen sind in Unteransprüchen gekennzeichnet.

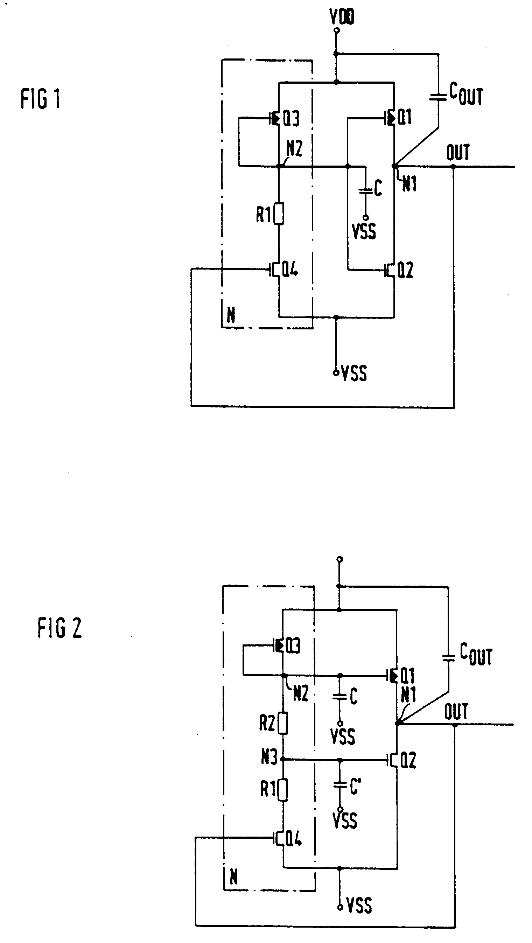

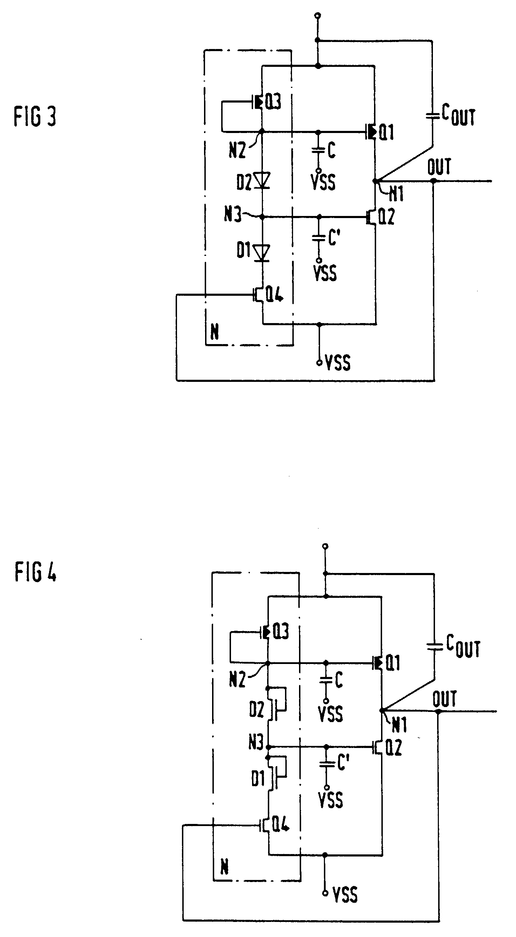

Nachstehend wird die Erfindung anhand der Zeichnung näher erläutert, wobei die Figuren 1-10 vorteilhafte Ausgestaltungen und Anwendungen der Erfindung zeigen.

Figur 1 zeigt die erfindungsgemäße integrierte Schaltung in ihrer Grundstruktur, allerdings bereits ergänzt um zwei (noch zu beschreibende) Kapazitäten als vorteilhafte Ausgestaltung der Grundstruktur. Die erfindungsgemäße Schaltung enthält in ihrer Grundstruktur zwei erste Transistoren Q1, Q2 vom zueinander komplementären Kanaltyp. Der eine erste Transistor Q1 ist vom p-Kanaltyp. Entsprechend ist der andere erste Transistor Q2 vom n-Kanaltyp. Beide erste Transistoren Q1, Q2 sind mit ihren Kanalstrecken in Serie zueinander geschaltet und zwischen Anschlüssen für ein erstes (VDD) und ein zweites Versorgungspotential VSS angeordnet. Im vorliegenden und in den nachfolgenden Beispielen ist angenommen, daß das erste Versorgungspotential VDD im Betrieb einen positiveren Wert aufweist als das zweite Versorgungspotential VSS. Weiterhin ist zwischen den Anschlüssen für die beiden Versorgungspotentiale VDD, VSS, parallel zu den beiden ersten Transistoren Q1, Q2, ein serielles Netzwerk N angeordnet, welches als Spannungsteilerschaltung wirkt. Es enthält zwei zweite Transistoren Q3, Q4, die ebenfalls vom zueinander entgegengesetzten Kanaltyp sind. Der eine zweite Transistor Q3 ist vom p-Kanaltyp, während der andere zweite Transistor Q4 vom n-Kanaltyp ist. Zwischen den beiden zweiten Transistoren Q3, Q4 ist ein Widerstand R1 angeordnet. An ihm fällt, ebenso wie entlang den Kanalstrecken der beiden zweiten Transistoren Q3, Q4, im Betrieb eine Spannung ab. Allerdings hängt der Spannungsabfall entlang des Widerstandes R1, wie jeder Fachmann weiß, in erster Linie von der Beschaffenheit (d.h. z.B. Dimensionierung) des Widerstandes R1 ab, während die Spannungsabfälle entlang den zweiten Transistoren Q3, Q4 in erster Linie davon abhängen, ob ihre Kanalstrecken durchgeschaltet sind (niederohmiger Bahnwiderstand) oder ob sie gesperrt sind (hochohmiger Bahnwiderstand). Im Gegensatz zum Wert des Widerstandes R1 sind also die Widerstände der zweiten Transistoren Q3, Q4 schaltbar, d.h. durch die Betriebsverhältnisse nichtstetig veränderbar.

Die Sources der beiden Transistoren Q1, Q3 vom einen Kanaltyp sind mit dem Anschluß für das erste Versorgungspotential VDD verbunden. Die Sources der beiden Transistoren Q2, Q4 vom anderen Kanaltyp sind mit dem Anschluß für das zweite Versorgungspotential VSS verbunden.

Die Drainanschlüsse der beiden ersten Transistoren Q1, Q2 bilden einen ersten Schaltungsknoten N1. Im Betrieb entsteht an diesem (N1) das Reset-Signal OUT. Darüber hinaus ist der erste Schaltungsknoten N1 mit dem Gate des zweiten Transistors Q4 vom anderen Kanaltyp verbunden, so daß im Betrieb das Reset-Signal OUT auf das Gate des zweiten Transistors Q4 vom anderen Kanaltyp rückgekoppelt ist und diesen (Q4) steuert.

Die Gates der ersten und zweiten Transistoren vom einen Kanaltyp Q1, Q3 sind, unter Bildung eines zweiten Schaltungsknotens N2, beide mit der Drain des zweiten Transistors Q3 vom einen Kanaltyp verbunden. Die ersten und zweiten Transistoren vom einen Kanaltyp Q1, Q3 wirken somit als Stromspiegelschaltung.

Das Gate des ersten Transistors Q2 vom anderen Kanaltyp ist in der Ausführungsform nach Figur 1 unmittelbar mit dem zweiten Schaltungsknoten N2 verbunden, so daß in dieser Ausführungsform die beiden ersten Transistoren Q1, Q2 einen CMOS-Inverter bilden.

Uber diese Grundstruktur der erfindungsgemäßen Schaltung hinaus weist die Schaltung nach Figur 1 noch eine Kapazität C auf, welche zwischen den Gates der beiden ersten Transistoren Q1, Q2 einerseits und dem zweiten Versorgungspotential VSS andererseits angeordnet ist, sowie eine weitere Kapazität C_{OUT}, welche zwischen dem ersten Schaltungsknoten N1 und dem ersten Versorgungspotential VDD angeordnet ist. Die Kapazitäten C, C_{OUT} dienen einem Filtern von an den jeweiligen Schaltungsknoten N1, N2 eventuell auftretenden Störsignalen, d.h. also beispielsweise einem Glätten von unerwünschten Störspannungsspitzen.

Die erfindungsgemäße Schaltung nach Figur 1 funktioniert folgendermaßen:

Zunächst weisen angenommenermaßen beide Versorgungspotentiale VDD, VSS den Wert "Masse" auf. Das zweite Versorgungspotential VSS behält diesen Wert im weiteren Verlauf bei. Das erste Versorgungspotential VDD hingegen wird "eingeschaltet", d.h. der Potentialwert am Anschluß für das erste Versorgungspotential VDD steigt, ausgehend von demjenigen des zweiten Versorgungspotentials VSS, an bis zum gewünschten Endwert des ersten Versorgungspotentials VDD, z.B. 3 V oder 5 V.

Die beiden Schaltungsknoten N1, N2 weisen zunächst den jeweils aktuellen Wert des ersten Versorgungspotentials VDD auf, d.h., ausgehend vom Wert des zweiten Versorgungspotentials VSS steigen die Potentialwerte an den beiden Schaltungsknoten N1, N2 an mit dem Ansteigen des ersten Versorgungspotentials VDD. Somit weist auch das Reset-Signal OUT eine ansteigende Flanke auf. Dies geschieht solange, bis das Reset-Signal OUT einen Wert aufweist, bei dem der zweite Transistor Q4 vom anderen Kanaltyp, der ja Bestandteil des als Spannungsteilerschaltung wirkenden seriellen Netzwerkes N ist, leitend wird aufgrund des Anliegens des Reset-Signals OUT an seinem (Q4) Gate. Dieser Zeitpunkt läßt sich mit tl bezeichnen. Zum Zeitpunkt tl ändern sich also die Spannungsverhältnisse an den einzelnen Elementen des Netzwerkes N, denn die Drain des zweiten Transistors Q4 vom anderen Kanaltyp wird in Richtung zweites Versorgungspotential VSS, d.h. in Richtung Masse gezogen. Somit sinkt zwar, wegen des Widerstandes R1, auch das Potential am zweiten Schaltungsknoten N2 ab in Richtung des Wertes des zweiten Versorgungspotentials VSS, allerdings nur in sehr geringem Maße, verglichen mit dem Zustand, in dem der zweite Transistor Q4 vom anderen Kanaltyp sperrt.

Ab dem Zeitpunkt tl weisen somit die beiden Schaltungsknoten N1, N2 wegen der Stromspiegeleigenschaft der beiden Transistoren Q1, Q3 vom einen Kanaltyp (diese sind elektrisch leitend) und wegen der Spannungsteilereigenschaft des seriellen Netzwerkes N ein Potential auf, das niedriger ist als der aktuelle Wert des ersten Versorgungspotentials VDD. Bei einem weiteren Ansteigen des Wertes des ersten Versorgungspotentials VDD steigt auch das Potential an den beiden Schaltungsknoten N1, N2 weiter an, allerdings nur bis zu einem Wert, bei dem der erste Transistor Q2 vom anderen Kanaltyp leitend wird. Dieser Zeitpunkt läßt sich mit t2 bezeichnen. Wenn nun (zum Zeitpunkt t2) der erste Transistor Q2 vom anderen Kanaltyp elektrisch leitend wird, so wird das zweite Versorgungspotential VSS auf den ersten Schaltungsknoten N1 durchgeschaltet, so daß das Reset-Signal OUT abfällt in etwa auf den Wert des zweiten Versorgungspotentials VSS. Damit wird aber auch der zweite Transistor Q4 vom anderen Kanaltyp wieder gesperrt. Dies wirkt sich wegen der Spannungsteilereigenschaft des seriellen Netzwerkes N auf den zweiten Schaltungsknoten N2 dahingehend aus, daß dessen Potential wieder ansteigt in Richtung des Wertes des ersten Versorgungspotentials VDD. Der erste Transistor Q2 vom anderen Kanaltyp wird dadurch noch stärker durchgeschaltet.

Wenn nun das Potential am zweiten Schaltungsknoten N2 angestiegen ist bis zu einem Wert, der sich vom aktuellen Wert des ersten Versorgungspotentials VDD höchstens um den Wert der Einsatzspannung der beiden Transistoren Q1, Q3 vom einen Kanaltyp unterscheidet, dann sperren diese beiden Transistoren Q1, Q3, so daß zum einen zwischen den Anschlüssen für die Versorgungspotentiale VDD, VSS über die erfindungsgemäße Schaltung kein Querstrom (mehr) fließen kann und daß zum anderen das Reset-Signal OUT stets in etwa den Wert des zweiten Versorgungspotentials VSS aufweist: Sollte nämlich das Potential am zweiten Schaltungsknoten N2 absinken in Richtung des zweiten Versorgungspotentials VSS (so daß die Gefahr entstünde, daß der erste Transistor Q2 vom anderen Kanaltyp wieder gesperrt würde), dann begänne der zweite Transistor Q3 vom einen Kanaltyp zu leiten, so daß das Potential am zweiten Schaltungsknoten wieder anstiege in Richtung des Wertes des ersten Versorgungspotentials VDD. Damit aber bleibt der erste Transistor Q2 vom anderen Kanaltyp elektrisch leitend; das Reset-Signal OUT bleibt auf seinem (niedrigen) Wert.

Die erfindungsgemäße Schaltung hat folgende Vorteile, die sich anhand des oben Gesagten leicht nachvollziehen lassen:

Derjenige Wert des ersten Versorgungspotentials VDD, bei dem der erste Transistor Q2 vom anderen Kanaltyp vom gesperrten Zustand in den leitenden Zustand übergeht (und bei dem demzufolge das Reset-Signal OUT einen Potentialwert annimmt, der im wesentlichen dem Wert des zweiten Versorgungspotentials VSS entspricht), ist leicht definierbar durch Festlegen der Spannungsteilerverhältnisse, d.h. durch geeignetes Dimensionieren der Elemente des seriellen Netzwerkes N, nämlich durch Festlegen der Bahnwiderstände der zweiten Transistoren Q3, Q4 im leitenden Zustand und durch Festlegen des Wertes des ohm'schen Widerstandes R1. Bei Verwenden der erfindungsgemäßen Schaltung als sogenannte "Power-on-Detection"-Schaltung läßt sich somit mit einfachen Mitteln derjenige Wert des ersten Versorgungspotentials VDD festlegen, der als "Power-on" zu detektieren ist.

Weiterhin ist die Schaltung sehr betriebssicher, da zu Beginn des Anschaltens des ersten Versorgungspotentials VDD sämtliche Schaltungsknoten der Schaltung potentialmäßig festgelegt sind (zweites Versorgungspotential VSS).

Darüber hinaus ist die erfindungsgemäße Schaltung unabhängig von der Anstiegszeit des ersten Versorgungspotentials VDD, d.h. unabhängig davon, ob beim Einschalten das erste Versorgungspotential VDD schnell oder langsam ansteigt. Diese Unabhängigkeit ist dadurch gewährleistet, daß (aufgrund der Spannungsteilerfunktion des seriellen Netzwerkes N) der zweite Transistor Q4 vom anderen Kanaltyp stets früher leitend geschaltet wird als der erste Transistor Q2 vom anderen Kanaltyp.

Figur 2 zeigt eine vorteilhafte Weiterbildung der erfindungsgemäßen Schaltung, bei der das Gate des ersten Transistors Q2 vom anderen Kanaltyp über einen zweiten Widerstand R2 mit dem zweiten Schaltungsknoten N2 verbunden ist. Das serielle Netzwerk N mit seiner Spannungsteilereigenschaft wird bei der Ausgestaltung nach Figur 2 also gebildet aus einer Serienschaltung des zweiten Transistors Q3 vom einen Kanaltyp, den beiden Widerständen R2, R1 und aus dem zweiten Transistor Q4 vom anderen Kanaltyp. Dabei bildet der Verbindungspunkt zwischen dem Gate des ersten Transistors Q2 vom anderen Kanaltyp und den beiden Widerständen R1, R2 einen dritten Schaltungsknoten N3. Das Gate des ersten Transistors Q2 vom anderen Kanaltyp ist vorteilhafterweise, analog der entsprechenden Ausgestaltung der Schaltung nach Figur 1 und zu demselben Zweck, über eine Kapazität C' mit dem zweiten Versorgungspotential VSS verbunden. Bei dieser Ausführungsform liegen an den Gates der beiden ersten Transistoren Q1, Q2 demzufolge voneinander verschiedene Potentiale an, so daß die Schaltung insgesamt noch einfacher für die beabsichtigten Einsatzzwecke dimensionierbar ist als diejenige nach Figur 1.

Bei der Ausführungsform nach Figur 3 sind die Widerstände R1, R2 ersetzt durch Dioden D1, D2. Damit lassen sich im Betrieb ebenfalls genau definierbare Spannungsabfälle (entlang der Dioden D1, D2) erzielen, die ab einem durch die Dimensionierung der Gesamtschaltung vorgegebenen Wert des ersten Versorgungspotentials VDD unabhängig vom aktuellen Wert des ersten Versorgungspotentials VDD sind.

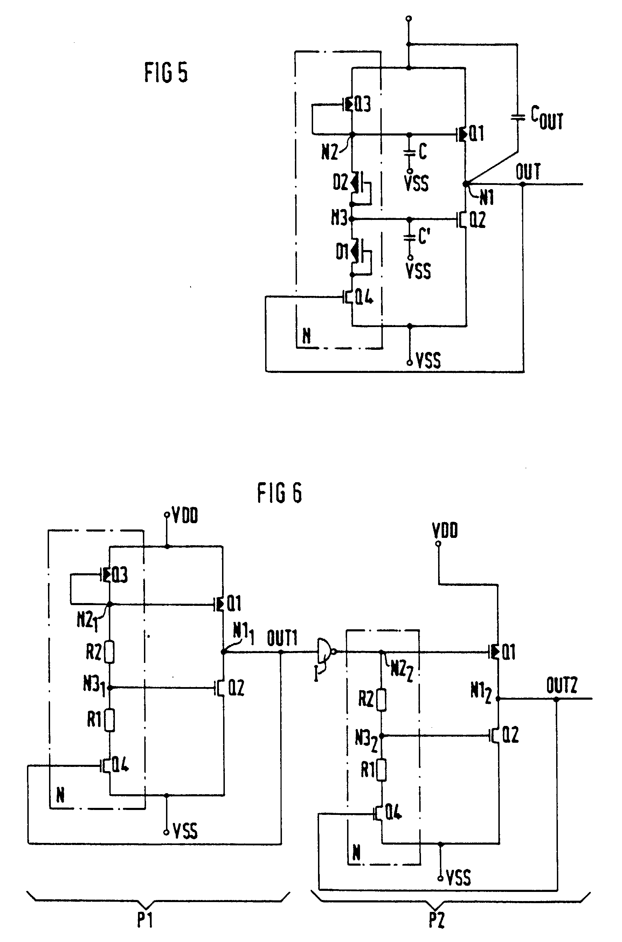

In den Figuren 4 und 5 sind die Dioden D1, D2 als Transistoren vom n- bzw. vom p-Kanaltyp realisiert, deren Drains jeweils mit dem zugehörigen Gate verbunden sind. Es ist auch möglich, statt einer Diode D1, D2 bzw. anstelle eines Widerstandes R1, R2 jeeweils eine Serienschaltung einer Diode D1 (bzw. D2) mit einem Widerstand R1 (bzw. R2) vorzusehen.

Nachstehend werden anhand der Figuren 6 bis 10 einige vorteilhafte Anwendungsmöglichkeiten der erfindungsgemäßen Schaltung beschrieben.

Die Anwendungsform nach Figur 6 dient einer Erzeugung mehrerer, verschiedener Reset-Signale OUT1, OUT2. Sie enthält einen ersten Schaltungsteil P1, der gemäß einer der bislang bereits beschriebenen Ausführungsformen ausgestaltet sein kann, beispielsweise derjenigen nach Figur 2 (die Kapazitäten C, C', C_{OUT} sind dabei weggelassen). Dem ersten Schaltungsteil P1 ist ein zweiter Schaltungsteil P2 nachgeschaltet. Der zweite Schaltungsteil P2 ist gleich dem ersten Schaltungsteil, und somit gleich der Grundstruktur der erfindungsgemäßen integrierten Schaltung ausgestaltet mit folgender Ausnahme: Beim seriellen Netzwerk N entfällt der eine zweite Transistor Q3 vom einen Kanaltyp. Stattdessen ist der zweite Schaltungsknoten N2₂ des zweiten Schaltungsteils P2 mit dem ersten Schaltungsknoten N1₁ des ersten Schaltungsteils P1 verbunden. Die Verbindung kann entweder direkt erfolgen oder über einen Inverter I, wie dargestellt. Der Inverter I kann dabei als Bestandteil des seriellen Netzes N wirken entsprechend dem einen zweiten Transistor Q3 nach Figur 2. Es ist auch möglich, daß die Verbindung mittels eines als Diode geschalteten Transistors erfolgt. Im Betrieb entsteht am ersten Schaltungsknoten N1₁ des ersten Schaltungsteils P1 ein erstes Reset-Signal OUT1. Dieses dient gleichzeitig als Eingangssignal für den zweiten Schaltungsteil P2. Am ersten Schaltungsknoten N1₂ des zweiten Schaltungsteils P2 entsteht das zweite Reset-Signal OUT2. Mit einer solchen Anordnung lassen sich zwei Reset-Signale OUT1, OUT2 kaskadiert erzeugen, wobei das zweite Reset-Signal OUT2 vom Auftreten des ersten Reset-Signals OUTl abhängt. Weiterhin ist das Auftreten jedes dieser Reset-Signale OUT1, OUT2 von der Dimensionierung ihres jeweils zugehörigen Schaltungsteils P1 bzw. P2 abhängig.

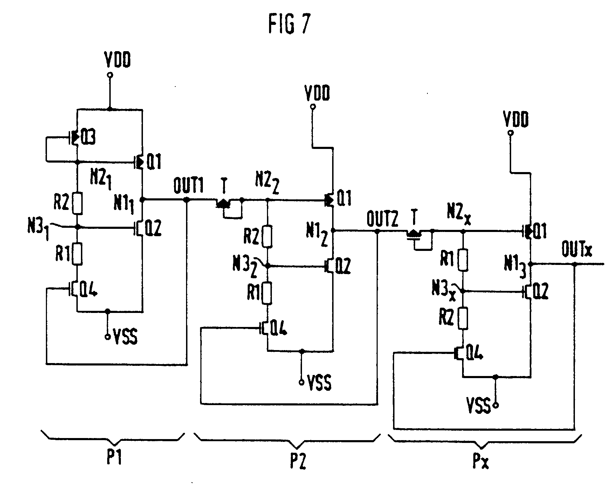

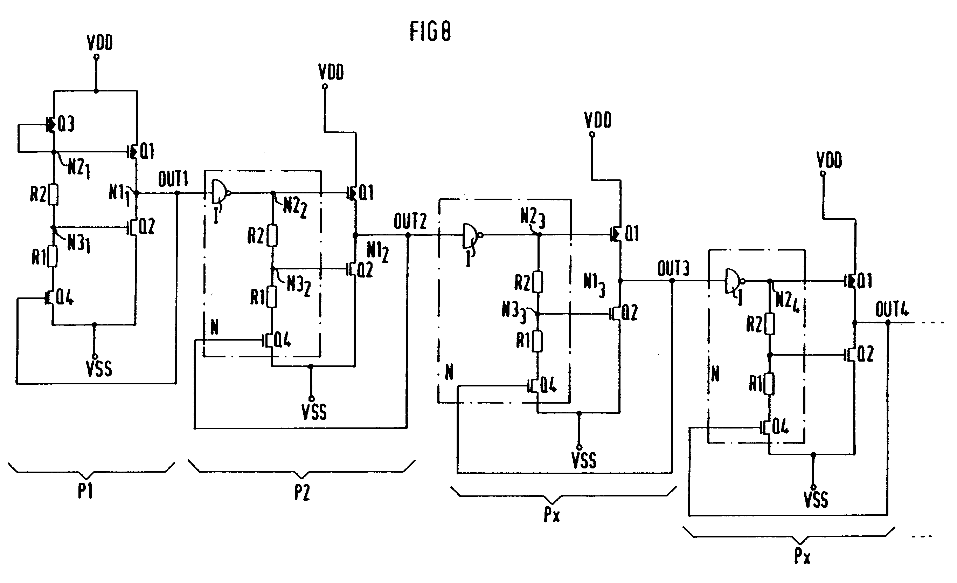

Figur 7 zeigt ein weiteres Beispiel für ein Kaskadieren der erfindungsgemäßen Schaltung: Diese Anwendung enthält einen ersten und einen zweiten Schaltungsteil P1, P2, angeordnet entsprechend dem Beispiel nach Figur 6. Dem zweiten Schaltungsteil P2 ist ein weiterer Schaltungsteil Px nachgeschaltet. Der weitere Schaltungsteil Px ist genauso aufgebaut wie der zweite Schaltungsteil P2. Er ist dem zweiten Schaltungsteil P2 auf dieselbe Art nachgeschaltet wie dieser (P2) dem ersten Schaltungsteil P1. Dieses Kaskadieren von Schaltungsteilen P1, P2, Px läßt sich mit mehr als einem weiteren Schaltungsteil Px fortführen, wie in Figur 8 anhand von insgesamt zwei weiteren Schaltungsteilen Px gezeigt. Weiterhin ist in Figur 7 auch gezeigt, daß der Inverter I des zweiten (P2) bzw. weiteren Schaltungsteils (Px) durch einen Transistor (T) ersetzbar ist, dessen Gate mit der Drain verbunden ist.

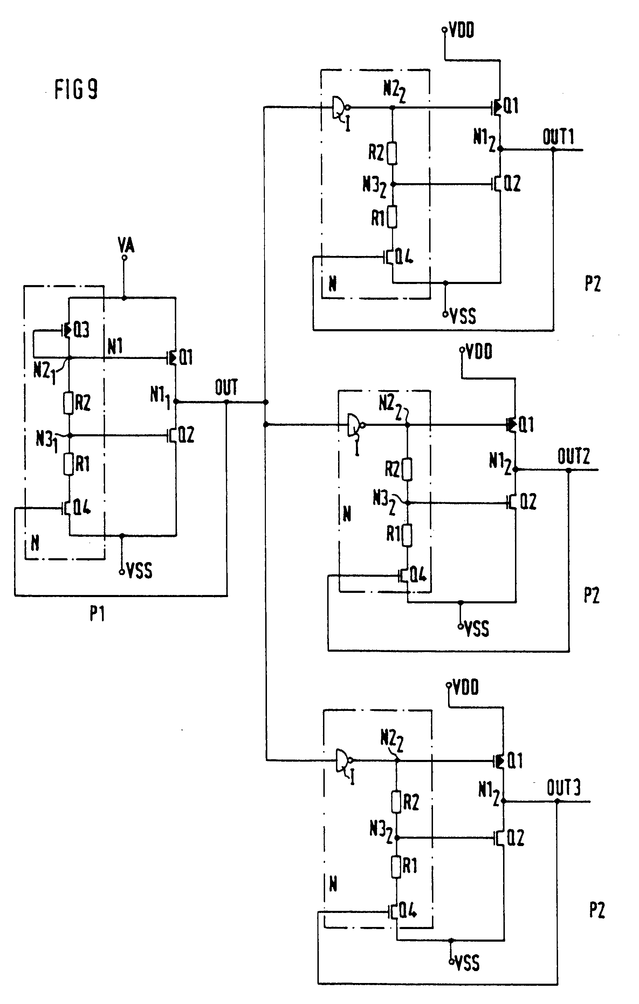

Figur 9 zeigt eine weitere vorteilhafte Anwendung der erfindungsgemäßen Schaltung, nämlich eine Anwendung als Analog-/Digital-Wandlerschaltung. Diese weist einen ersten Schaltungsteil P1 auf und (beispielsweise) drei zweite Schaltungsteile P2. Der erste Schaltungsteil P1 ist genauso aufgebaut wie der erste Schaltungsteil P1 in der Figur 6 beispielsweise. Allerdings ist sein Anschluß für das erste Versorgungspotential VDD im Betrieb nicht mit diesem (VDD) verbunden, sondern mit einem zu digitalisierenden Analogpotential VA. Die zweiten Schaltungsteile P2 sind genauso aufgebaut wie der zweite Schaltungsteil P2 in der Figur 6 beispielsweise. Allerdings sind die Elemente der zweiten Schaltungsteile P2, insbesondere die des jeweiligen seriellen Netzes N, von zweitem Schaltungsteil P2 zu zweitem Schaltungsteil P2 verschieden dimensioniert. Die zweiten Schaltungsteile P2 sind eingangsmäßig zusammengeschaltet: Ihre zweiten Schaltungsknoten N2₂ sind jeweils mit dem ersten Schaltungsknoten N1₁ des ersten Schaltungsteils P1 verbunden, beispielsweise (wie dargestellt) über Inverter I. Im Betrieb treten, bei geeigneter Dimensionierung der Schaltungsteile P1, P2, die Reset-Signale OUT1, OUT2, OUT3 auf in Abhängigkeit vom Wert des an den ersten Schaltungsteil P1 angelegten, zu digitalisierenden Analogpotentials VA.

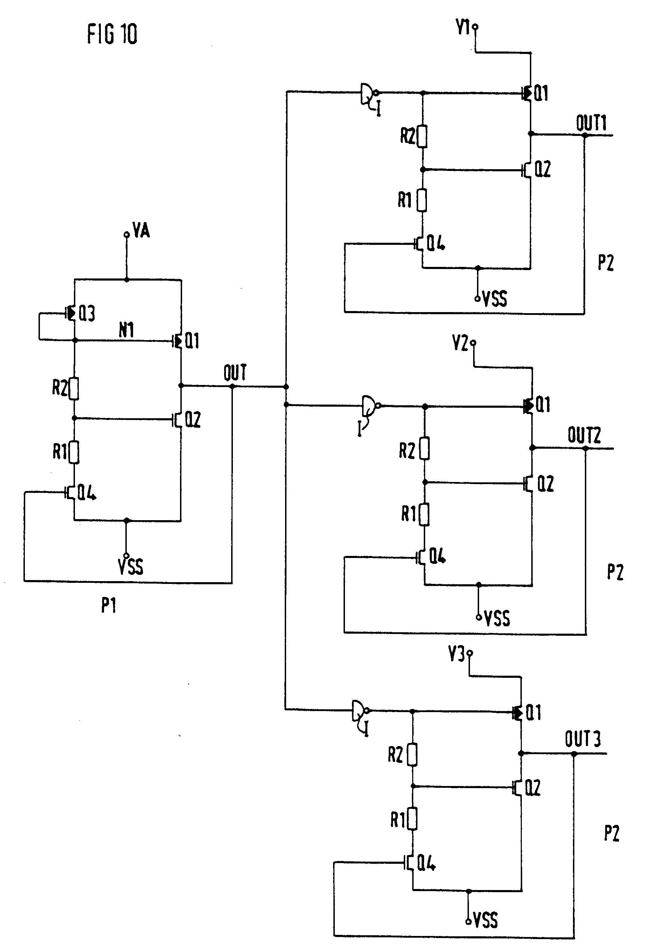

Figur 10 zeigt eine Anordnung entsprechend Figur 9 mit der Ausnahme, daß bei den zweiten Schaltungsteilen P2 der Anschluß für das erste Versorgungspotential VDD nicht mit dem ersten Versorgungspotential VDD verbunden ist, sondern jeweils mit einem Referenzpotential V1, V2, V3. Die Referenzpotentiale V1, V2, V3 sind voneinander verschieden. Die seriellen Netzwerke N der zweiten Schaltungsteile P2 können voneinander verschieden dimensioniert sein wie bei der Anordnung nach Figur 9; sie können jedoch auch untereinander gleich dimensioniert sein. Auch hier treten im Betrieb, bei geeigneter Dimensionierung der Schaltungsteile P1, P2 und der Referenzpotentiale V1, V2, V3, die Reset-Signale OUT1, OUT2, OUT3 auf in Abhängigkeit vom Wert des an den ersten Schaltungsteil P1 angelegten, zu digitalisierenden Analogpotentials VA.

Die in den Figuren 6 bis 10 gezeigten Inverter sind Bestandteil des jeweiligen seriellen Netzes N. Ihre Dimensionierung wirkt sich demzufolge auf die Spannungsteilereigenschaft des jeweiligen seriellen Netzes N aus.

## Patentansprüche

1. Integrierte Schaltung zur Erzeugung eines Reset-Signales (OUT) mit folgenden Merkmalen:
- zwischen Anschlüssen für ein erstes und ein zweites Versorgungspotential (VDD, VSS) sind zwei erste in Serie zueinander geschaltete Transistoren (Q1, Q2) vom zueinander komplementären Kanaltyp angeordnet,
- weiterhin ist zwischen den Anschlüssen für das erste und das zweite Versorgungspotential (VDD, VSS) ein als Spannungsteilerschaltung wirkendes serielles Netzwerk (N) von wenigstens zwei zweiten mit ihren Kanalstrecken in Serie zueinander geschalteten Transistoren (Q3, Q4) vom zueinander komplementären Kanaltyp und wenigstens einem dazu in Serie geschalteten, im Betrieb einen Spannungsabfall aufweisenden Element (R1; R1, R2; D1, D2) angeordnet,
- die Sources der Transistoren vom einen Kanaltyp (Q1,Q3) sind mit dem Anschluß für das erste Versorgungspotential (VDD) verbunden,
- die Sources der Transistoren vom anderen Kanaltyp (Q2, Q4) sind mit dem Anschluß für das zweite Versorgungspotential (VSS) verbunden,
- die Drainanschlüsse der beiden ersten Transistoren (Q1, Q2) bilden einen ersten Schaltungsknoten (N1), an dem im Betrieb das Reset-Signal (OUT) entsteht,
- der erste Schaltungsknoten (N1) ist mit dem Gate des zweiten Transistors vom anderen Kanaltyp (Q4) verbunden,
- die Gates der ersten und zweiten Transistoren vom jeweils einen Kanaltyp (Q1, Q3) sind beide mit der Drain des zweiten Transistors vom einen Kanaltyp (Q3) des seriellen Netzwerkes (N) verbunden unter Bildung eines zweiten Schaltungsknotens (N2),
- das Gate des ersten Transistors vom anderen Kanaltyp (Q2) ist mit dem zweiten Schaltungsknoten (N2) verbunden,
- das wenigstens eine im Betrieb einen Spannungsabfall aufweisende Element (R1; R1, R2; D1, D2) des seriellen Netzwerkes (N) ist zwischen dem zweiten Schaltungsknoten (N2) und dem Drainanschluß des zweiten Transistors vom anderen Kanaltyp (Q4) angeordnet.

2. Integrierte Schaltung nach Anspruch 1,
**dadurch gekennzeichnet**, daß das serielle Netzwerk (N) wenigstens ein erstes (R1; D1) und ein zweites (R2; D2) in Serie zueinander geschaltetes, im Betrieb einen Spannungsabfall aufweisendes Element aufweist, und das Gate des ersten Transistors vom anderen Kanaltyp (Q2) über wenigstens das zweite (R2; D2) im Betrieb einen Spannungsabfall aufweisende Element mit dem zweiten Schaltungsknoten (N2) verbunden ist unter Bildung eines dritten Schaltungsknotens (N3).

3. Integrierte Schaltung nach Anspruch 1 oder 2,
**dadurch gekennzeichnet**, daß wenigstens einer der beiden ersten Transistoren (Q1, Q2) gatemäßig an das zweite Versorgungspotential (VSS) kapazitiv (C, C') angekoppelt ist.

4. Integrierte Schaltung nach einem der vorhergehenden Ansprüche,
**dadurch gekennzeichnet,** daß der erste Schaltungsknoten (N1) kapazitiv (C_{OUT}) an das erste Versorgungspotential (VDD) angekoppelt ist.

5. Integrierte Schaltung nach einem der vorhergehenden Ansprüche,
**dadurch gekennzeichnet**, daß wenigstens eines der im Betrieb den Spannungsabfall aufweisenden Elemente (R1, R2; D1, D2) ein ohm'scher Widerstand (R1, R2) ist.

6. Integrierte Schaltung nach einem der vorhergehenden Ansprüche,
**dadurch gekennzeichnet**, daß wenigstens eines der im Betrieb den Spannungsabfall aufweisenden Elemente (R1, R2; D1, D2) eine Diode (D1, D2) ist.

7. Integrierte Schaltung nach Anspruch 6,
**dadurch gekennzeichnet**,
daß die wenigstens eine Diode (D1, D2) als Transistor ausgebildet ist, dessen Gate mit seiner Drain verbunden ist.

8. Integrierte Schaltung zur Erzeugung von Reset-Signalen (OUT1, OUT2) mit folgenden Merkmalen:
- sie enthält einen ersten Schaltungsteil (P1), der gemäß der integrierten Schaltung nach einem der vorhergehenden Ansprüche ausgestaltet ist,
- sie enthält einen zweiten Schaltungsteil (P2), der gemäß der integrierten Schaltung nach einem der vorhergehenden Ansprüche ausgestaltet ist mit folgender Ausnahme:
- anstelle einer Verbindung zwischen dem Anschluß für das erste Versorgungspotential (VDD) und dem zweiten Versorgungsknoten (N2) über den einen zweiten Transistor (Q3) ist eine Verbindung zwischen dem zweiten Schaltungsknoten (N2₂) des zweiten Schaltungsteils (P2) und dem ersten Schaltungsknoten (N1₁) des ersten Schaltungsteils (P1) vorhanden,
- die Reset-Signale (OUT1, OUT2) entstehen am ersten Schaltungsknoten (N1₁, N1₂) des jeweiligen Schaltungsteils (P1, P2).

9. Integrierte Schaltung nach Anspruch 8,
**dadurch gekennzeichnet,**
daß der zweite Schaltungsknoten (N2₂) des zweiten Schaltungsteils (P2) mit dem ersten Schaltungsknoten (N1₁) des ersten Schaltungsteils (P1) über einen Inverter (I) gegeben ist.

10. Integrierte Schaltung nach Anspruch 9,
**dadurch gekennzeichnet,**
daß der Inverter (I) Bestandteil des seriellen Netzwerkes (N) des zweiten Schaltungsteils (P2) ist.

11. Integrierte Schaltung nach einem der Ansprüche 8 bis 12,
**dadurch gekennzeichnet,**
daß dem zweiten Schaltungsteil (P2) ein weiterer Schaltungsteil (Px) nachgeschaltet ist, der schaltungsmäßig ebenso aufgebaut ist wie der zweite Schaltungsteil (P2) und der dem zweiten Schaltungsteil (P2) auf dieselbe Art nachgeschaltet ist wie der zweite Schaltungsteil (P2) dem ersten Schaltungsteil (P1).

12. Integrierte Schaltung nach Anspruch 11,
**dadurch gekennzeichnet,**
daß mehr als ein weiterer Schaltungsteil (Px) vorhanden ist, die schaltungsmäßig ebenso aufgebaut sind wie der eine weitere Schaltungsteil (Px) und die einander ebenso nachgeschaltet sind wie der eine weitere Schaltungsteil (Px) dem zweiten Schaltungsteil (P2).

13. Als Analog-/Digitalwandlerschaltung ausgebildete integrierte Schaltung mit den Merkmalen eines der Patentansprüche 8 bis 10 und mit folgenden weiteren Merkmalen:
- der Anschluß des ersten Schaltungsteiles (P1) für das erste Versorgungspotential (VDD) ist anstelle mit dem ersten Versorgungspotential (VDD) mit einem zu digitalisierenden Analogpotential (VA) verbunden,
- die Schaltung weist mehr als einen zweiten Schaltungsteil (P2) auf, deren zweite Schaltungsknoten (N2₂) mit dem ersten Schaltungsknoten (N1₁) des ersten Schaltungsteils (P1) verbunden sind,
- die serialen Netzwerke (N) der zweiten Schaltungsteile (P2) sind als Spannungsteilerschaltungen mit voneinander unterschiedlichen Spannungsteilerwerten ausgelegt.

14. Als Analog-/Digitalwandler ausgebildete integrierte Schaltung mit den Merkmalen eines der Patentansprüche 8 bis 10 oder 13 und mit folgenden weiteren Merkmalen:
- der Anschluß des ersten Schaltungsteiles (P1) für das erste Versorgungspotential (VDD) ist anstelle mit dem ersten Versorgungspotential (VDD) mit einem zu digitalisierenden Analogpotential (VA) verbunden,
- die Schaltung weist mehr als einen zweiten Schaltungsteil (P2) auf, deren zweite Schaltungsknoten (N2₂) mit dem ersten Schaltungsknoten (N1₁) des ersten Schaltungsteils (P1) verbunden sind,
- bei jedem zweiten Schaltungsteil (P2) ist als erstes Versorgungspotential (VDD) ein Referenzpotential (V1, V2, V3) verwendet, wobei die einzelnen Referenzpotentiale (V1, V2, V3) verschieden voneinander sind.

## Claims

1. Integrated circuit for generating a reset signal (OUT), having the following features:
- two first, series-connected transistors (Q1, Q2) of mutually complementary channel types are arranged between terminals for a first and a second supply potential (VDD, VSS),
- furthermore, a serial network (N), acting as voltage divider circuit, of at least two second transistors (Q3, Q4) of mutually complementary channel types, which second transistors are connected in series with one another by their channel paths, and at least one element (R1; R1, R2; D1, D2), which is connected in series with the said second transistors and has a voltage drop during operation, is arranged between the terminals for the first and second supply potentials (VDD, VSS),
- the sources of the transistors of the first channel type (Q1, Q3) are connected to the terminal for the first supply potential (VDD),
- the sources of the transistors of the second channel type (Q2, Q4) are connected to the terminal for the second supply potential (VSS),
- the drain terminals of the two first transistors (Q1, Q2) form a first circuit node (N1), at which the reset signal (OUT) is produced during operation,
- the first circuit node (N1) is connected to the gate of the second transistor of the second channel type (Q4),
- the gates of the first and second transistors of the respective first channel type (Q1, Q3) are both connected to the drain of the second transistor of the first channel type (Q3) of the serial network (N), with the formation of a second circuit node (N2),
- the gate of the first transistor of the second channel type (Q2) is connected to the second circuit node (N2),
- the at least one element (R1; R1, R2; D1, D2) of the serial network (N), the said element having a voltage drop during operation, is arranged between the second circuit node (N2) and the drain terminal of the second transistor of the second channel type (Q4).

2. Integrated circuit according to Claim 1,
characterized in that the serial network (N) has at least one first (R1; D1) and one second (R2; D2) element having a voltage drop during operation, which are connected in series with one another, and the gate of the first transistor of the second channel type (Q2) is connected to the second circuit node (N2) via at least the second (R2; D2) element having a voltage drop during operation, with the formation of a third circuit node (N3).

3. Integrated circuit according to Claim 1 or 2,
characterized in that at least one of the two first transistors (Q1, Q2) is coupled capacitively (C, C') by its gate to the second supply potential (VSS).

4. Integrated circuit according to one of the preceding claims,
characterized in that the first circuit node (N1) is coupled capacitively (C_{OUT}) to the first supply potential (VDD).

5. Integrated circuit according to one of the preceding claims,
characterized in that at least one of the elements (R1, R2; D1, D2) having the voltage drop during operation is a non-reactive resistor (R1, R2).

6. Integrated circuit according to one of the preceding claims,
characterized in that at least one of the elements (R1, R2; D1, D2) having the voltage drop during operation is a diode (D1, D2).

7. Integrated circuit according to Claim 6,
characterized in that the at least one diode (D1, D2) is designed as a transistor whose gate is connected to its drain.

8. Integrated circuit for generating reset signals (OUT1, OUT2), having the following features:
- it contains a first circuit section (P1), which is configured in accordance with the integrated circuit according to one of the preceding claims,
- it contains a second circuit section (P2), which is configured in accordance with the integrated circuit according to one of the preceding claims with the following exception:
- instead of a connection between the terminal for the first supply potential (VDD) and the second supply node (N2) via the first second transistor (Q3), a connection between the second circuit node (N2₂) of the second circuit section (P2) and the first circuit node (N1₁) of the first circuit section (P1) is present,
- the reset signals (OUT1, OUT2) are produced at the first circuit node (N1₁, N1₂) of the respective circuit section (P1, P2).

9. Integrated circuit according to Claim 8,
characterized in that the second circuit node (N2₂) of the second circuit section (P2) is connected to the first circuit node (N1₁) of the first circuit section (P1) via an inverter (I).

10. Integrated circuit according to Claim 9,
characterized in that the inverter (I) is part of the serial network (N) of the second circuit section (P2).

11. Integrated circuit according to one of Claims 8 to 10,
characterized in that there is connected downstream of the second circuit section (P2) a further circuit section (Px), which is constructed in circuitry terms in the same way as the second circuit section (P2) and is connected downstream of the second circuit section (P2) in the same way as the second circuit section (P2) is connected downstream of the first circuit section (P1).

12. Integrated circuit according to Claim 11,
characterized in that more than one further circuit section (Px) is present, which further circuit sections are constructed in circuitry terms in the same way as the first further circuit section (Px) and are connected downstream of one another in the same way as the first further circuit section (Px) is connected downstream of the second circuit section (P2).

13. Integrated circuit designed as analogue/digital converter circuit and having the features of one of Patent Claims 8 to 10 and having the following further features:
- the terminal of the first circuit section (P1) for the first supply potential (VDD), rather than being connected to the first supply potential (VDD), is connected to an analogue potential (VA) to be digitized,
- the circuit has more than one second circuit section (P2), whose second circuit nodes (N22) are connected to the first circuit node (N1₁) of the first circuit section (P1),
- the serial networks (N) of the second circuit sections (P2) are designed as voltage divider circuits with mutually different voltage divider values.

14. Integrated circuit designed as analogue/digital converter and having the features of one of Patent Claims 8 to 10 or 13 and having the following further features:
- the terminal of the first circuit section (P1) for the first supply potential (VDD), rather than being connected to the first supply potential (VDD), is connected to an analogue potential (VA) to be digitized,
- the circuit has more than one second circuit section (P2), whose second circuit nodes (N2₂) are connected to the first circuit node (N1₁) of the first circuit section (P1),
- in the case of each second circuit section (P2), a reference potential (V1, V2, V3) is used as the first supply potential (VDD), the individual reference potentials (V1, V2, V3) being different from one another.

## Revendications

1. Circuit intégré pour la production d'un signal de remise à l'état initial (OUT) et ayant les caractéristiques suivantes :
- deux premiers transistors (Q1, Q2), montés en série et à canal de types complémentaires, sont montés entre des bornes destinées à un premier potentiel d'alimentation (VDD) et à un deuxième potentiel d'alimentation (VSS),
- un réseau série (N), agissant comme circuit diviseur de tension et formé d'au moins deux deuxièmes transistors (Q3, Q4), montés en série par leurs voies de canaux et à canal de types complémentaires, et d'au moins un élément (R1 ; R1, R2 ; D1, D2) monté en série avec ces transistors et présentant une chute de tension au cours du fonctionnement, est monté entre les bornes destinées au premier potentiel d'alimentation (VDD) et au deuxième potentiel d'alimentation (VSS),
- les sources des transistors (Q1, Q3) à canal de premier type sont reliées à la borne destinée au premier potentiel d'alimentation (VDD),
- les sources des transistors (Q2, Q4) à canal de second type sont reliées à la borne destinée au deuxième potentiel d'alimentation (VSS),
- les bornes de drains des deux premiers transistors (Q1, Q2) forment un premier noeud de circuit (N1), auquel le signal de remise à l'état initial (OUT) apparaît au cours du fonctionnement,
- le premier noeud de circuit (N1) est relié à la grille du deuxième transistor (Q4) à canal de second type,
- les grilles des premier et deuxième transistors (Q1, Q3) à canal de premier type sont reliées au drain du deuxième transistor (Q3) à canal de premier type du réseau série (N) en formant un deuxième noeud de circuit (N2),
- la grille du premier transistor (Q2) à canal de second type est reliée au deuxième noeud de circuit (N2),
- le ou les éléments (R1 ; R1, R2 ; D1, D2), présentant une chute de tension au cours du fonctionnement, du réseau série (N) est ou sont montés entre le deuxième noeud de circuit (N2) et la borne de drain du deuxième transistor (Q4) à canal de second type.

2. Circuit intégré selon la revendication 1,
caractérisé par le fait que le réseau série (N) comporte au moins un premier élément (R1 ; D1) et un deuxième élément (R2 ; D2) montés en série et présentant une chute de tension au cours du fonctionnement et la grille du premier transistor (Q2) à canal de second type est reliée au deuxième noeud de circuit (N2), au moins par l'intermédiaire du deuxième élément (R2 ; D2) présentant une chute de tension au cours du fonctionnement, en formant un troisième noeud de circuit (N3).

3. Circuit intégré selon la revendication 1 ou 2,
caractérisé par le fait qu'au moins l'un des deux premiers transistors (Q1, Q2) est couplé par sa grille, de manière capacitive (C, C'), au deuxième potentiel d'alimentation (VSS).

4. Circuit intégré selon l'une des revendications précédentes,
caractérisé par le fait que le premier noeud de circuit (N1) est couplé de manière capacitive (COUT) au premier potentiel d'alimentation (VDD).

5. Circuit intégré selon l'une des revendications précédentes,
caractérisé par le fait qu'au moins l'un des éléments (R1, R2 ; D1, D2) présentant une chute de tension au cours du fonctionnement est une résistance ohmique (R1, R2).

6. Circuit intégré selon l'une des revendications précédentes,
caractérisé par le fait qu'au moins l'un des éléments (R1, R2 ; D1, D2) présentant une chute de tension au cours du fonctionnement est une diode (D1, D2).

7. Circuit intégré selon la revendication 6,
caractérisé par le fait que la ou les diodes (D1, D2) est ou sont sous la forme de transistor dont la grille est reliée au drain.

8. Circuit intégré pour la production de signaux de remise à l'état initial (OUT1, OUT2) et ayant les caractéristiques suivantes :
- il comporte une première partie de circuit (P1) qui est sous la forme du circuit intégré selon l'une des revendications précédentes,
- il comporte une deuxième partie de circuit (P2) qui est sous la forme du circuit intégré selon l'une des revendications précédentes avec l'exception suivante :
- au lieu d'une liaison entre la borne destinée au premier potentiel d'alimentation (VDD) et le deuxième noeud de circuit (N2) par l'intermédiaire d'un deuxième transistor (Q3), il est prévu une liaison entre le deuxième noeud de circuit (N2₂) de la deuxième partie de circuit (P2) et le premier noeud de circuit (N1₁) de la première partie de circuit (P1),
- les signaux de remise à l'état initial (OUT1, OUT2) apparaissent au premier noeud de circuit (N1₁, N1₂) de la partie de circuit (P1, P2) respective.

9. Circuit intégré selon la revendication 8,
caractérisé par le fait que le deuxième noeud de circuit (N2₂) de la deuxième partie de circuit (P2) est relié au premier noeud de circuit (N1₁) de la première partie de circuit (P1) par l'intermédiaire d'un inverseur (I).

10. Circuit intégré selon la revendication 9,
caractérisé par le fait que l'inverseur (I) fait partie du réseau série (N) de la deuxième partie de circuit (P2).

11. Circuit intégré selon l'une des revendications 8 à 12,
caractérisé par le fait qu'il est monté du côté aval de la deuxième partie de circuit (P2) une autre partie de circuit (Px), dont le circuit est formé exactement de la même façon que la deuxième partie de circuit (P2) et qui est montée du côté aval de la deuxième partie de circuit (P2) de la même manière que la deuxième partie de circuit (P2) est montée du côté aval de la première partie de circuit (P1).

12. Circuit intégré selon la revendication 11,
caractérisé par le fait qu'il y a plus d'une autre partie de circuit (Px) dont le circuit est formé respectivement exactement de la même façon que l'autre partie de circuit (Px) et qui sont montées en aval les unes des autres de la même manière que l'autre partie de circuit (Px) est montée du côté aval de la deuxième partie de circuit (P2).

13. Circuit intégré sous la forme d'un circuit convertisseur analogique-numérique et ayant les caractéristiques de l'une des revendications 8 à 10, ainsi que les caractéristiques supplémentaires suivantes :
- la borne de la première partie de circuit (P1) destinée au premier potentiel d'alimentation (VDD) est reliée, non au premier potentiel d'alimentation (VDD), mais à un potentiel analogique (VA) à numériser,
- le circuit comporte plus d'une deuxième partie de circuit (P2), dont les deuxièmes noeuds de circuit (N2₂) sont reliés au premier noeud de circuit (N1₁) de la première partie de circuit (P1),
- les réseaux séries (N) des deuxièmes parties de circuit (P2) sont sous la forme de circuits diviseurs de tensions avec des valeurs de division de tension différentes les unes des autres.

14. Circuit intégré sous la forme d'un convertisseur analogique-numérique et ayant les caractéristiques de l'une des revendications 8 à 10 ou 13, ainsi que les caractéristiques supplémentaires suivantes :
- la borne de la première partie de circuit (P1) destinée au premier potentiel d'alimentation (VDD) est reliée, non au premier potentiel d'alimentation (VDD), mais à un potentiel analogique (VA) à numériser,
- le circuit comporte plus d'une deuxième partie de circuit (P2), dont les deuxièmes noeuds de circuit (N2₂) sont reliés au premier noeud de circuit (N1₁) de la première partie de circuit (P1),
- dans chaque deuxième partie de circuit (P2), il est utilisé, comme premier potentiel d'alimentation (VDD), un potentiel de référence (V1, V2, V3), les potentiels de référence (V1, V2, V3) étant différents les uns des autres.
